(19) Europäisches Patentamt
European Patent Office
Office européen des brevets

(11) **EP 0 416 858 B1**

(12) **EUROPEAN PATENT SPECIFICATION**

(45) Date of publication and mention
of the grant of the patent:
**27.03.1996 Bulletin 1996/13**

(51) Int Cl.[6]: **G02F 3/00**, H01L 31/105,
H01L 31/0352, G02F 3/02

(21) Application number: **90309642.8**

(22) Date of filing: **04.09.1990**

(54) **A light detection method**

Lichtdetektionsmethode

Méthode de détection de lumière

(84) Designated Contracting States:
**DE FR NL**

(30) Priority: **06.09.1989 JP 232211/89**
**06.09.1989 JP 232212/89**

(43) Date of publication of application:
**13.03.1991 Bulletin 1991/11**

(73) Proprietor: **MITSUBISHI DENKI KABUSHIKI KAISHA**
**Tokyo (JP)**

(72) Inventor: **Tokuda, Yasunori**
**c/o MITSUBISHI DENKI K. K.**
**Amagasaki-shi Hyogo-ken (JP)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
- **NIKKEI HIGH TECH REPORT vol. IV, no. 14, 22 May 1989, TOKYO, JP page 2 "LIGHT WAVELENGTH CHANGES STATE OF PHOTOELECTRIC DEVICE"**
- **APPLIED PHYSICS LETTERS. vol. 54, no. 23, 05 June 1989, NEW YORK US pages 2324 - 2326; Y.TOKUDA ET AL.: "SELF DEFORMED AND HYSTERETIC PHOTOCURRENT SPECTRA OF QUANTUM WELLS WITH A LOAD RESISTOR"**
- **APPLIED PHYSICS LETTERS. vol. 55, no. 8, 21 August 1989, NEW YORK US pages 711 - 712; T.YOKUDA ET AL.: "INCIDENT WAVELENGTH DEPENDENCE OF PHOTOCURRENT**
- **BISTABILITY BY EXTERNAL BIAS VOLTAGE CONTROL IN A QUANTUM WELL p-i-n DIODE"**
- **APPLIED PHYSICS LETTERS. vol. 65, no. 5, 01 March 1989, NEW YORK US pages 2168 - 2170; T.YOKUDA ET AL.: "ANOMALOUS EXCITATION-INTENSITY DEPENDENCE OF PHOTOLUMINESCENCE PROPERTIESOF AN ASSYMETRIC COUPLED QUANTUM WELL STRUCTURE"**
- **APPLIED PHYSICS LETTERS. vol. 47, no. 3, 01 August 1985, NEW YORK US pages 190 - 192; T.H.WOOD ET AL.: "WAVELENGTH-SELECTIVE VOLTAGE TUNABLE PHOTODETECTOR MADE FROM MULTIPLE QUANTUM WELLS"**
- **APPLIED PHYSICS LETTERS. vol. 45, no. 1, 01 July 1984, NEW YORK US pages 13 - 15; D.A.B.MILLER ET AL.: "NOVEL HYBRID OPTICALLY BISTABLE SWITCH : THE QUANTUM WELL SELF ELCTRO-OPTIC EFFECT DEVICE"**
- **APPLIED PHYSICS LETTERS Vol.54(13), 27 March 1989, pages 1232-1234**

## Description

### APPLICABLE FIELD IN THE INDUSTRY

The present invention relates to method for detecting light which shows a high sensitivity response to light signal at a particular wavelength range, and to an element showing optical multiple stability.

### BACKGROUND OF THE INVENTION

A light detection method utilizing a quantum well with wavelength selectivity is recited in, for example, Appl. Phys. Lett. Vol.47, No.3, (1985), pp. 190 to 192. The method is based on the principle which will be described.

The quantum well structure exhibits exciton absorption at a room temperature and the absorption characteristics thereof is considerably sharp.

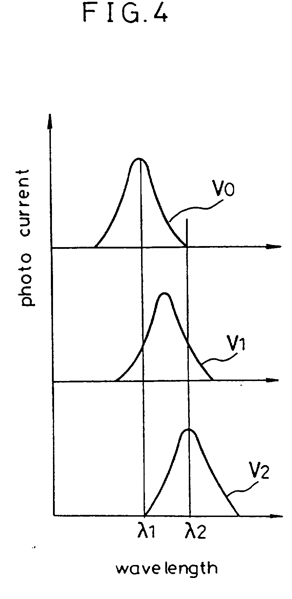

Figure 4 shows photocurrent spectra in case where various reverse bias voltage are applied to the quantum well structure. In figure 4, the relation of the reverse bias voltages $V_0$, $V_1$, and $V_2$ is $V_0 < V_1 < V_2$.

As shown in figure 4, when a reverse bias voltage is applied to a quantum well structure, the absorption peak of incident light in the quantum well layer shifts toward the longer wavelength side by the quantum confined Stark effect. Accordingly, an external electric field which is applied to the structure makes the absorption peak shift to the wavelength to be detected, so that the light detection can be performed with high wavelength selectivity.

Furthermore, the incident light can be resolved into lights of wavelength $\lambda_1$ and $\lambda_2$ shown in figure 4 utilizing such wavelength selectivity of the quantum well structure.

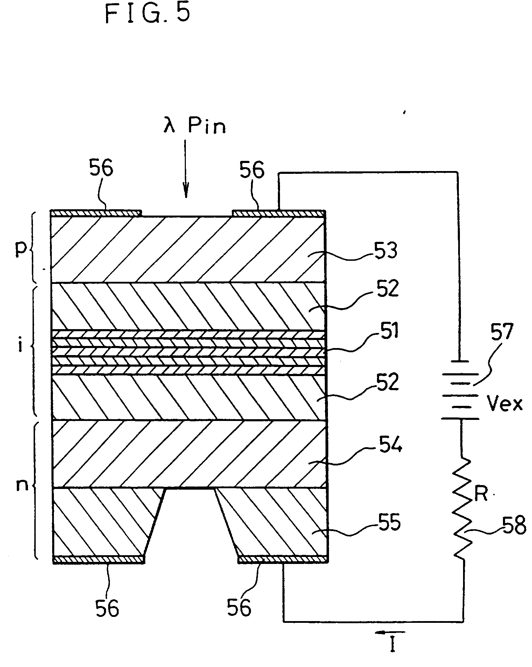

Figure 5 is a diagram showing a construction of Self-electro-optic effect element and an external circuit driving the same, which is recited in, for example, Appl. Phys. lett., Vol.45, No. 1 (1984) pp.13 to 15.

In figure 5, reference numeral 51 designates a GaAs/AlGaAs multi-quantum well region which is put between undoped AlGaAs layers 52. A p type AlGaAs layer 53 and an n type AlGaAs layer 54 are disposed so as to put between this undoped laminated structure from above and below. This p-i-n structure is disposed on an n type GaAs substrate 55 having an aperture in the central portion. An electrode 56 is produced on a rear surface of the substrate 55 and on the p type AlGaAs layer 53. An aperture for incident light is provided on the electrode 56 on the p type AlGaAs layer 53. An external power supply 57 and a resistor 58 are connected in series between the upper and lower electrodes 56 as an external circuit.

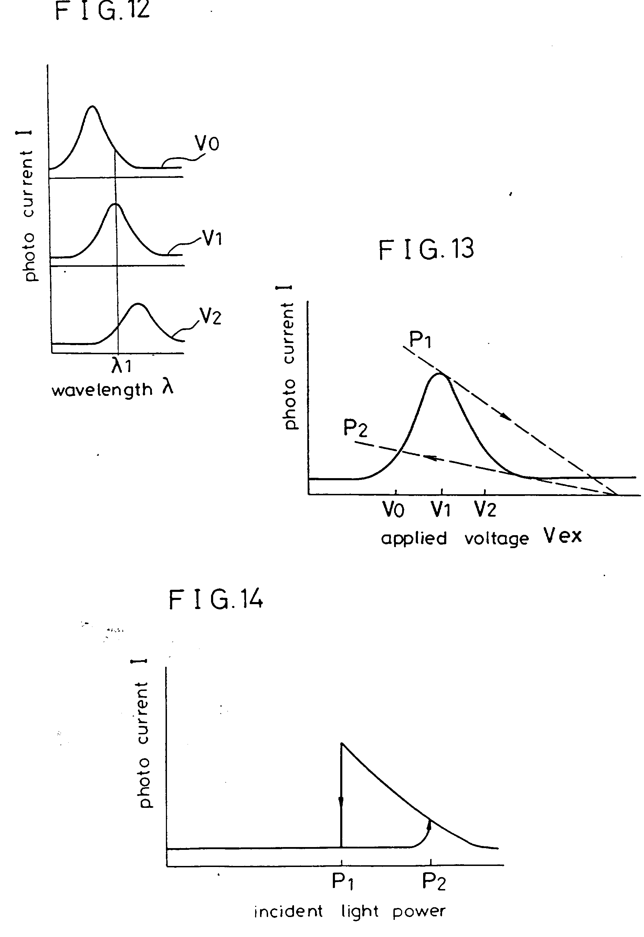

Figure 12 shows photocurrent spectra against three applied voltages ($V_0 < V_1 < V_2$) when the external resistor 58 is not connected ($R = 0\Omega$). Figure 13 shows photocurrent response against applied voltage at the wavelength $\lambda_1$. The quantum well structure generally has a characteristics that the absorption peak shifts toward the longer wavelength side, as shown in figure 12, with relative to the increase in the external applied voltage $V_{ex}$, as described above.

Next, a description will be given of the operation.

When the light signal of the wavelength $\lambda$ and intensity $P_{in}$ is input from the aperture of the upper side electrode 56, the photocurrent flows in accordance with the absorption characteristics of the element including the quantum well structure. The characteristics in a case where the external resistor 58 is not connected to the element are as those shown in figures 12 and 13. On the other hand, when the external resistor 58 is connected to the element, a voltage drop IR arises induced by the photocurrent I, which makes the voltage applied to the element self-modulated. Thus, also the photocurrent I is again modulated.

The load characteristics is represented by following formula:

$$I = \frac{C}{P_{in} R} (V_{ex} - V) \qquad (1)$$

where C is a constant.

The cross point between the light response curve of figure 13 and the straight line represented by the formula (1) results in as a solution. The load characteristics against two incident light power $P_1$ and $P_2$ ($P_1 < P_2$) are shown by dotted straight lines in figure 13, and then the response characteristics of this element (incident light power-photocurrent characteristics) becomes as shown in figure 14, resulting in that bistable property can be obtained in a range between $P_1$ and $P_2$.

Similarly, the bistable property can be obtained in the characteristics of the photocurrent against the applied voltage $V_{ex}$, the external resistor R, and the wavelength $\lambda$.

The above-described prior art light detection method using a quantum well structure having wavelength selectivity utilizes absorption spectrum in nature and it has a problem in its resolution.

Furthermore, the hybrid type optical bistable element of figure 5 was one which takes only two stables states in accordance with external parameters such as light input, applied voltage, external resistor, and wavelength.

### SUMMARY OF THE INVENTION

It is an object of the present invention to provide a method of opticaldetection which has quite high resolution, capable of selectively detecting light at a particular wavelength range and electrically controlling the width of the wavelength range.

It is another object of the present invention to provide an optical multi-stable element capable of selecting more than three stable points in accordance with the external parameters.

Other objects and advantages of the present invention will become apparent from the detailed description given hereinafter.

According to a first aspect of the present invention, an external resistor is connected in series to a p-i-n type diode having a quantum well structure in the i region so as to obtain two bistable wavelength range in the photocurrent, and the optical detection with high wavelength selectivity is performed utilising the steep absorption edges thereof and the highly sensitive region put between the absorption edges. Therefore, this light detection method has quite high wavelength resolution. Furthermore, light of particular wavelength range can be selectively detected and further the width of the wavelength can be electrically controlled. For example such properties can be achieved for a coupled quantum well structure.

According to a second aspect of the present invention, an optical multi-stable element includes a coupled quantum well structure in which a thicker well and a thinner well are provided separated by a thin barrier for the i layer of the p-i-n structure and utilizes the anti-crossing phenomenon of the optical absorption transition which is induced by changing the electric field. This coupled quantum well induces the anti-crossing phenomenon, thereby providing two peaks in the voltage-photocurrent characteristics. Therefore, the tri-stable property can be easily obtained by connecting a load resistor in series.

BRIEF DESCRIPTION OF THE DRAWINGS

Figure 1 is a diagram showing the construction of the light detection method in accordance with a first embodiment of the present invention;

Figure 2 is a diagram showing the photocurrent- voltage characteristics (A, B, C), when the resistor is not connected to the element of figure 1, and the load characteristics (a, b);

Figure 3 is a diagram showing the photocurrent spectrum against the straight lines of load a and b shown in figure 2;

Figure 4 is a diagram showing the voltage dependency of the photocurrent spectrum in the prior art quantum well p-i-n type diode;

Figure 5 is a diagram showing a construction of an optical stable element in accordance with the prior art,

Figure 6 is a diagram showing the conduction band of the coupled quantum well in accordance with the first and second embodiment of the present invention;

Figure 7 is a diagram showing the voltage dependency of the photocurrent spectrum in the optical multi-stable element when the resistor is not connected to the element in accordance with the second embodiment of the first and second aspect of the present invention;

Figure 8 is a diagram showing the relationship between the photocurrent and the load voltage and the characteristics against four incident light powers (or four resistors) at the wavelength $\lambda = \lambda_1$ in figure 7, in a real curved line and broken straight lines, respectively;

Figure 9 is a diagram showing the tri-stability against the incident light power (or resistor) of the light multi-stable element at the wavelength $\lambda = \lambda_1$ in accordance with the second embodiment of the present invention, which is induced from the characteristics shown by the figure 8;

Figure 10 is a diagram showing the relationship between the photocurrent and the voltage and the load characteristics against the four external voltages at the wavelength $\lambda = \lambda_1$ in figure 7, in a real curved line and broken straight lines, respectively;

Figure 11 is a diagram showing the characteristics of tri-stable property against the external voltage of the light multi-stable element at the wavelength $\lambda = \lambda_1$ in accordance with the second embodiment of present invention, which is induced from the characteristics shown by the figure 10;

Figure 12 is a diagram showing the dependency of the photocurrent spectrum on the voltage of the prior art light bistable element when the resistor is not connected to the element;

Figure 13 is a diagram showing the relation between the photocurrent and the voltage and the load characteristics against two incident light power at a wavelength $\lambda = \lambda_1$ in figure 12, in a real curved line and broken straight lines, respectively; and

Figure 14 is a diagram showing the bistability of light against the incident optical power of the prior art light bistable element at a wavelength $\lambda = \lambda_1$, which is induced from the characteristics shown by the figure 13.

DETAILED DESCRIPTION OF THE EMBODIMENT

An embodiment of the present invention will be described in detail with reference to the drawings.

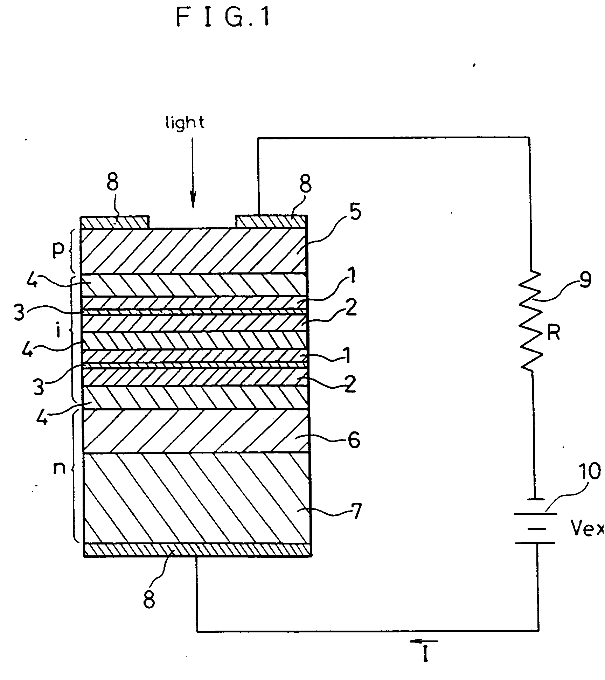

Figure 1 is a diagram showing a construction of a photodetector utilized in a method for detecting light in accordance with a first embodiment of the present invention. In figure 1, reference numerals 1 and 2 designate GaAs quantum well layers. An AlAs layer 3 is sandwiched between the GaAs quantum well layers 1 and 2.

Both of the two laminated structures of layers 1, 3, and 2 provided at upper and lower side respectively are put between by undoped AlGaAs layers 4, which are provided totally in three pieces. A p type AlGaAs layer 5 and an n type AlGaAs layer 6 are disposed on the upper and lower surface of this structure, respectively. An n type GaAs substrate 7 is provided at the rear surface of the layer 6. An upper and lower side electrodes 8 are produced on the both surface of the element. As shown in figure 1, a resistor R 9 and the power supply voltage $V_{ex}$ 10 are connected in series to this element.

A description will be given of the operation.

When a light signal is input to the element, a photocurrent flows in accordance with the absorption characteristics of the element including the quantum well structure. Since this photocurrent I induces a voltage drop IR at the resistor R 9 the voltage V applied to the element becomes $V_{ex}$ - IR. Herein, when the absorption spectrum is shifted by the electric field which is applied thereto, the photocurrent I varies by itself, and this load characteristics can be represented as follows:

$$I = \frac{1}{R} (V_{ex} - V) \qquad (2)$$

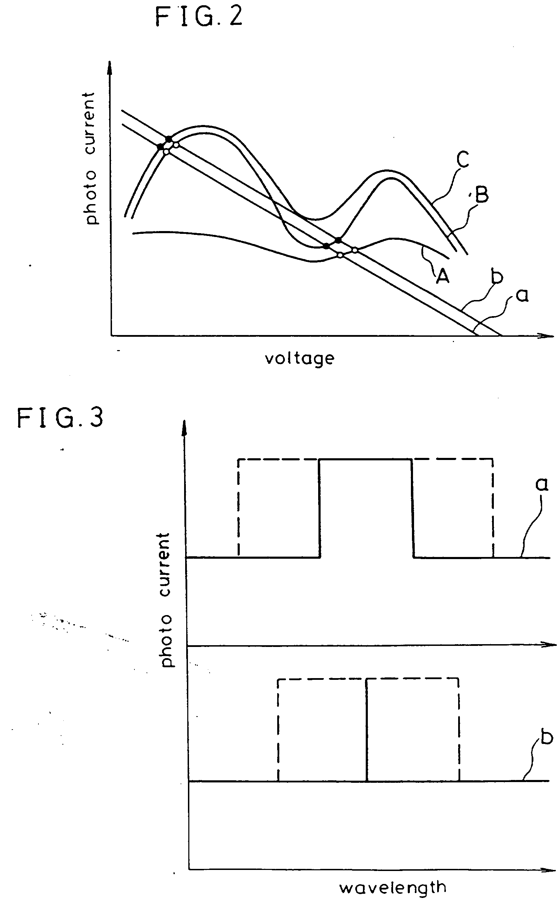

Now suppose that the relation between the applied voltage and the photocurrent when the resistor 9 is not connected to the element varies from the real curved line A to the real curved line B, from B to C, from C to B, and from B to A with the wavelength of incident light successively shortened as shown in the schematic view of figure 2. Furthermore, Suppose that the bottom values between the first and second peaks of photocurrent becomes the maximum at a particular wavelength, and further, the peak of photocurrent at lower voltage side become lower as the incident light is shifting from that wavelength.

Such characteristics can be obtained by using the anti-crossing phenomenon of quantum levels in the asymmetric coupled quantum well structure of figure 1 in which, for example, the thickness of the GaAs quantum well 1 is 8 nm, the thickness of the GaAs quantum well 2 is 10 nm, and the thickness of the AlAs layer 3 is 0.8 nm.

Figure 3 is a schematic view showing the photocurrent spectra (characteristics of photocurrent against wavelength) which are obtained for the two load characteristics straight lines (a) and (b) of figure 2. In figure 3, a broken line and a real line each represents a stable state. In the spectrum of the line (a) of figure 3, the rectangular center part of the real line is a high photocurrent response region and this is sandwiched by two bistable wavelength regions both sides thereof. When a monochromatic light of the bistable wavelength region is input to the element, the element exhibits a response of low current level represented by the lower real line.

In other words, the response of the element against the monochromatic signal light is represented by the real line of figure 3. Here, when the external applied voltage $V_{ex}$ is increased, since the load straight line shifts from (a) to (b) as seen from the formula (2), the wavelength range of high current level at the center portion of real line in figure 3 is reduced, and it can be reduced, in principle, to infinitesimal as shown in figure 3.

As described above, the element having characteristics such as in figure 2 can be used as a photodetector element with wavelength selectivity in which the element shows high sensitivity against a light signal within a particular wavelength range. Furthermore, the high sensitivity wavelength range can be controlled by an external applied voltage.

In the above-described embodiment, the quantum well comprises an asymmetric coupled quantum well structure in which a thicker well and a thinner well are separated by a thin barrier, but this structure always need not be of asymmetric configuration. A quantum well comprising other multiple quantum well structure or any other structure can be used only on a condition that the structure shows wavelength dependency of response as shown in figure 2.

In the above-described embodiment, the element which exhibits a response in photocurrent against incident light is employed as a type of optical detection. This element can be modified to an element of a transmission type element by removing a part of substrate of the element so as to enable transmission of light, and this modified element can be used as a filter-like element which only shuts off the light of a particular wavelength range.

Next, an optical multi-stable element in accordance with a second embodiment of the present invention will be described in detail with reference to the drawings.

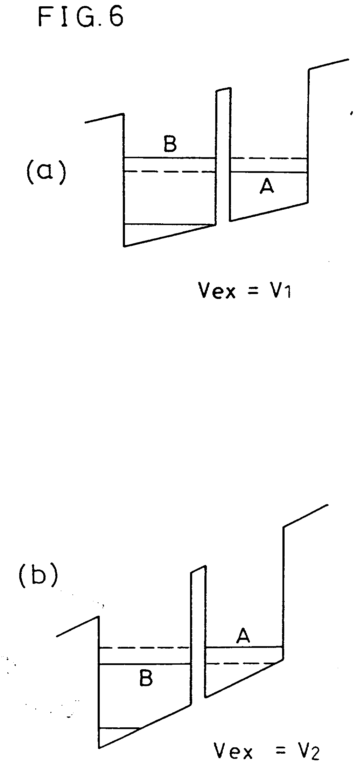

The element of this embodiment has the same structure as that of figure 1. However, in this embodiment, property in the asymmetric coupled quantum well structure is explained in detail. The conduction band structure thereof varies in accordance with the applied voltage $V_{ex}$ from $V_1$ to $V_2$ as shown in figure 6 (a) and (b).

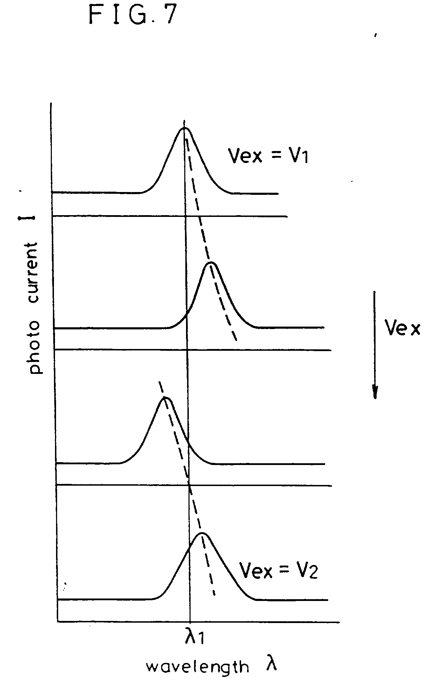

For the applied voltage $V_1$, the quantized level A is lower in energy than B, while, for $V_2$, level B is lower in energy than A. At that time, the strong coupling between wells (by means of a thin barrier layer) makes the levels A and B repel each other. Effected by this, when the voltage is increased from $V_1$ to $V_2$, as shown in figure 7, the optical transition relating to, for example, the level A varies discontinuously , which is called anti- crossing phenomenon.

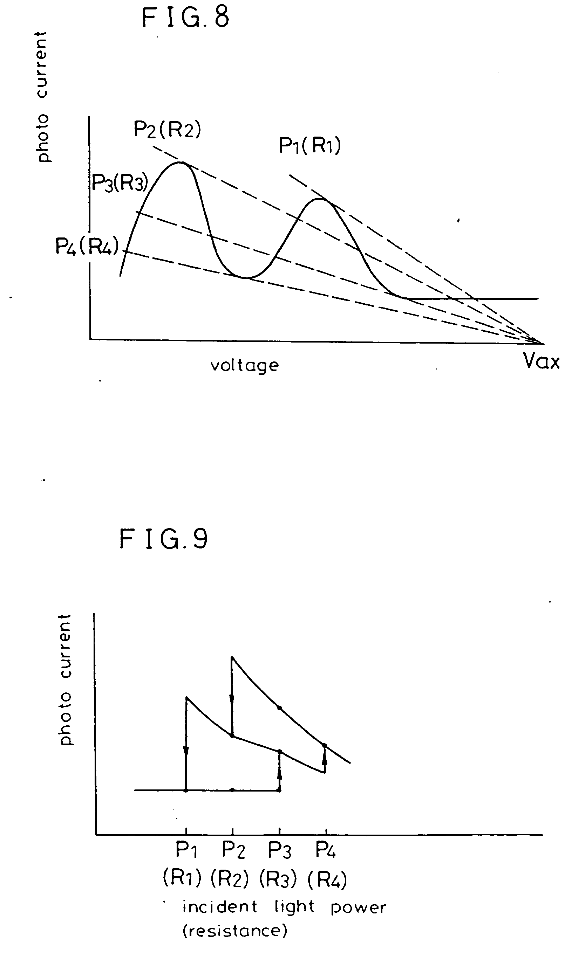

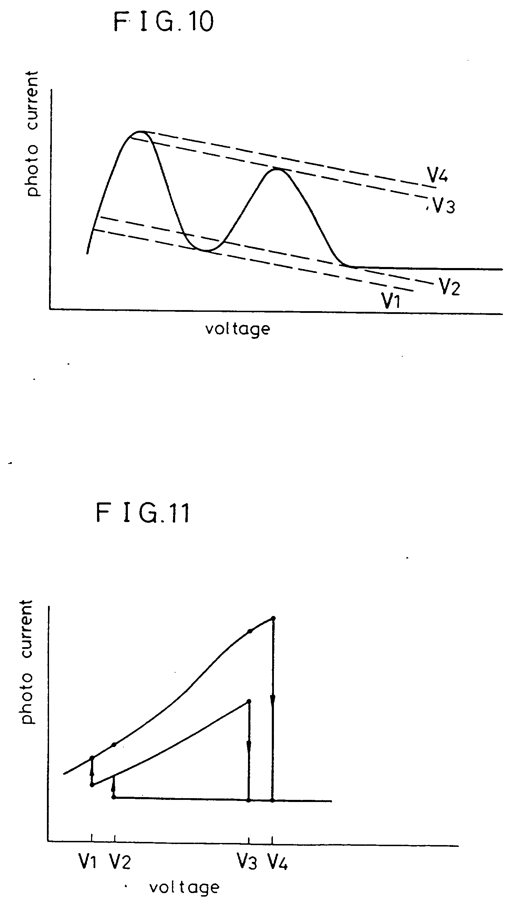

In this embodiment, the relation between the photocurrent and a voltage at the wavelength $\lambda_1$ is represented by the real curved line of figure 8 from the anti- crossing phenomenon. The cross points between the real curved line and each broken line representing the load characteristics result in solutions in a circuit in which the external resistor R and the external power supply are provided. Figure 8 shows the load characteristics against four incident light powers ($P_1$ to $P_4$) or resistors ($R_1$ and $R_4$). The characteristics shown by the figure 8 produces the photocurrent response shown in the figure 9 against the incident light power (resistor). As shown in figure 9, there is obtained a tri-stable state at a range between $P_2$ and $P_3$ (or $R_2$ and $R_3$). Furthermore, with respect to the variation in the applied voltage $V_{ex}$, the characteristics indicated by figure 11 can be obtained from figure 10 showing voltage-photocurrent characteristics and four load characteristics, in which a tri-stability is obtained in a range between $V_2$ and $V_3$. There can be also obtained a tri-stability at a particular wavelength range with relative to the wavelength variation.

Although an element showing a tri-stability with respect to photocurrent is shown in the above, an element showing a tri-stability can be obtained with respect to transmitting light similarly by removing a part of the substrate as discussed above.

In the above-described embodiment an element comprising asymmetric double quantum well structure is employed, but the present invention can be generally applied to an element having other structure in which anti-crossing characteristics are obtained with a variable voltage range in the coupled quantum well.

In the above-described embodiment the coupled quantum well structure is used to obtain two peaks shown in figures 8 and 10 produced by an exciton transition but such a line having two peaks can be obtained by using the heavy-hole exciton and the light-hole exciton in a conventional quantum well structure shown in Figure 5.

Furthermore, if a curved line having more than three peaks in a relation between the photocurrent and the voltage is produced, multi-stability can be obtained.

## Claims

1. A method of optical detection comprising:

   directing light onto a p-i-n type diode having a coupled quantum well structure for the i layer;
   applying a reverse bias voltage to said diode;
   inducing an anti-crossing in the light absorption transition of the quantum well structure so as to create a tri-stable device;
   measuring the photocurrent produced by the diode; and
   varying the value of the reverse bias voltage so as to vary the width of the wavelength band of light producing an increased photocurrent.

2. An optical detection method as claimed in Claim 1, including the step of varying the electric field applied across the diode so as to induce said anti-crossing.

3. An optical detection method according to Claim 1, including the step of:

   connecting an external resistor in series with said p-i-n type diode; and

applying a reverse bias voltage to said p-i-n type diode through said external resistor so as to induce said anti-crossing.

4. An optical detection method as claimed in Claim 3, including the step of varying the value of the external resistor so as to induce said anti-crossing.

5. An optical detection method as claimed in Claim 1, including the step of varying the wavelength of the light directed onto the diode so as to induce said anti-crossing.

6. An optical detection method as claimed in any one of the preceding claims, wherein said coupled quantum well structure is of an asymmetric structure.

7. An optical detection method as claimed in Claim 6, wherein said coupled quantum well structure is composed of a thicker quantum well and a thinner quantum well separated by a thin barrier layer.

8. An optical element comprising:

   a p-i-n type diode including a quantum well structure for the i layer;
   said quantum well structure for said i layer being a coupled quantum well structure in which a thicker well layer and a thinner well layer are provided separated by a thin barrier layer, the optical element including means for applying an electric field across the coupled quantum well structure, and means to induce an anti-crossing in the light absorption transition so as to enable said optical element to operate as a tri-stable element.

9. An optical element as claimed in Claim 8, including means for varying the electric field applied across the coupled quantum well structure so as to induce the anti-crossing.

10. An optical element as claimed in Claim 8, including an external resistor connected in series with said diode effective to apply a reverse bias voltage across the diode so as to induce the anti-crossing.

11. An optical element as defined in Claim 8, including means for varying the incident light power so as to induce said anti-crossing.

12. An optical element as claimed in Claim 8, including means for varying the incident light wavelength so as to induce said anti-crossing.

**Patentansprüche**

1. Optisches Erfassungsverfahren, welches aufweist:

   Ausrichten von Licht auf eine Diode vom p-i-n-Typ mit einer gekoppelten Quantentopfstruktur für die i-Schicht;

   Anlegen einer Sperrspannung an die Diode;

   Induzieren eines Nicht-Kreuzens bzw. Nicht-Überlappens in dem Lichtabsorptionsübergang der Quantentopfstruktur, um eine tri-stabile Vorrichtung zu erzeugen;

   Messen des von der Diode erzeugten Photostroms; und

   Variieren des Wertes der Sperrspannung, um die Breite des Wellenlängenbereichs des Lichts zu verändern, um einen erhöhten Photostrom zu erzeugen.

2. Optisches Erfassungsverfahren nach Anspruch 1, welches den Schritt des Variierens des über die Diode angelegten elektrischen Feldes aufweist, um das Nicht-Kreuzen zu induzieren.

3. Optisches Erfassungsverfahren nach Anspruch 1, welches den Schritt aufweist:

   Verbinden eines externen Widerstandes in Reihe an die Diode vom p-i-n-Typ; und

   Anlegen einer Sperrspannung an die Diode vom p-i-n-Typ, um das Nicht-Kreuzen zu induzieren

4. Optisches Erfassungsverfahren nach Anspruch 3, welches den Schritt des Variierens des externen Widerstandwertes aufweist, um das Nicht-Kreuzen zu induzieren.

5. Optisches Erfassungsverfahren nach Anspruch 1, welches den Schritt des Variierens der Wellenlänge des auf die Diode gerichteten Lichtes aufweist, um das Nicht-Kreuzen zu induzieren.

6. Optisches Erfassungsverfahren nach einem der vorhergehenden Ansprüche, bei dem die gekoppelte Quantentopfstruktur eine asymmetrische Struktur aufweist.

7. Optisches Erfassungsverfahren nach Anspruch 6, bei dem die Quantentopfstruktur aus einem dickeren Quantentopf und einem durch eine dünne Sperrschicht davon getrennten dünneren Quantentopf besteht.

8. Optisches Element, welches aufweist:

   eine p-i-n-Diode mit einer Quantentopfstruktur für die i-Schicht;

   wobei die Quantentopfstruktur für die i-Schicht eine gekoppelte Quantentopfstruktur ist, bei der eine dickere Topfschicht und eine dünnere Topfschicht von einer dünnen Sperrschicht voneinander getrennt vorgesehen sind, und wobei das optische Element eine Einrichtung zum Anlegen eines elektrischen Feldes über die gekoppelte Quantentopfstruktur sowie eine Einrichtung zum Induzieren von Nicht-Kreuzen bzw. Nicht-Überlappen in dem Lichtabsorptionsübergang aufweist, um den Betrieb des optischen Elementes als tri-stabiles Element zu ermöglichen.

9. Optisches Element nach Anspruch 8, welches eine Einrichtung zum Variieren des über die gekoppelte Quantentopfstruktur angelegten elektrischen Feldes aufweist, um das Nicht-Kreuzen zu induzieren.

10. Optisches Element nach Anspruch 8, welches einen in Reihe mit der Diode verbundenen externen Widerstand aufweist, der das Anlegen einer Sperrspannung über die Diode bewirkt, um das Nicht-Kreuzen zu induzieren.

11. Optisches Element nach Anspruch 8, welches eine Einrichtung zum Variieren der Leistung des einfallenden Lichtes aufweist, um das Nicht-Kreuzen zu induzieren.

12. Optisches Element nach Anspruch 8, welches eine Einrichtung zum Variieren der Wellenlänge des einfallenden Lichtes aufweist, um das Nicht-Kreuzen zu induzieren.

**Revendications**

1. Méthode de détection optique consistant à :

   diriger la lumière sur une diode du type p-i-n ayant une structure des puits quantiques couplés pour la couche i ;

   appliquer une tension de polarisation inverse à ladite diode ;

   induire un anti-croisement dans la transition d'absorption de la lumière de la structure de puits quantiques afin de créer un dispositif tristable ;

   mesurer le photo-courant produit par la diode ;

changer la valeur de la tension de polarisation inverse afin de changer la largeur de la bande des longueurs d'onde de la lumière produisant un photo-courant accru.

2. Méthode de détection optique de la revendication 1 comprenant l'étape de changer le champ électrique appliqué à travers la diode afin d'induire ledit anti-croisement.

3. Méthode de détection optique selon la revendication 1 comprenant l'étape de :

   connecter une résistance externe en série avec ladite diode du type p-i-n ; et

   appliquer une tension de polarisation inverse à ladite diode du type p-i-n à travers ladite résistance externe afin d'induire ledit anti-croisement.

4. Méthode de détection optique selon la revendication 3 comprenant l'étape de changer la valeur de la résistance externe afin d'induire ledit anti-croisement.

5. Méthode de détection optique selon la revendication 1 comprenant l'étape de changer la longueur d'onde de la lumière dirigée sur la diode afin d'induire ledit anti-croisement.

6. Méthode de détection optique selon l'une quelconque des revendications précédentes où ladite structure de puits quantiques couplés est une structure asymétrique.

7. Méthode de détection optique selon la revendication 6 où ladite structure de puits quantiques couplés se compose d'un puits quantique plus épais et d'un puits quantique plus mince qui sont séparés par une couche formant barrière mince.

8. Elément optique comprenant :

   une diode du type p-i-n comprenant une structure à puits quantiques pour la couche i ;

   ladite structure à puits quantiques pour ladite couche i étant une structure à puits quantiques couplés où une couche de puits plus épais et une couche de puits plus mince sont prévues qui sont séparées par une couche formant barrière mince, l'élément optique comportant un moyen pour appliquer un champ électrique à travers la structure de puits quantiques couplés et un moyen pour induire un anti-croisement dans la transition d'absorption de la lumière afin de permettre audit élément optique de fonctionner comme un élément tristable.

9. Elément optique selon la revendication 8 comprenant un moyen pour changer le champ électrique appliqué à travers la structure à puits quantiques couplés afin d'induire l'anti-croisement.

10. Elément optique selon la revendication 8 comprenant une résistance externe connectée en série avec ladite diode, servant à appliquer une tension de polarisation inverse à travers la diode afin d'induire l'anti-croisement.

11. Elément optique selon la revendication 8 comprenant un moyen pour changer la puissance de la lumière incidente afin d'induire ledit anti-croisement.

12. Elément optique selon la revendication 8 comprenant un moyen pour changer la longueur d'onde de la lumière incidente afin d'induire ledit anti-croisement.

# F I G.1

FIG. 2

FIG. 3

# F I G. 4

FIG. 5

FIG. 6

(a)

$Vex = V_1$

(b)

$Vex = V_2$

F I G. 7

FIG. 8

FIG. 9

FIG.10

FIG.11

F I G. 12

F I G. 13

F I G. 14